# EUROPEAN PATENT SPECIFICATION

(11) **EP 3 673 506 B1**
(45) Date of publication and mention of the grant of the patent: **15.11.2023**
(21) Application number: 18848860.5
(22) Date of filing: 23.08.2018
(51) Int. Cl.: H01L 21/67, H01L 21/673, H01L 21/68, H01L 21/683, H01L 21/687

(54) **SEMICONDUCTOR SUBSTRATE SUPPORT WITH MULTIPLE ELECTRODES AND METHOD FOR MAKING SAME**
TRÄGER FÜR HALBLEITERSUBSTRAT MIT MEHREREN ELEKTRODEN UND VERFAHREN ZU SEINER HERSTELLUNG
SUPPORT DE SUBSTRAT SEMI-CONDUCTEUR AYANT DE MULTIPLES ÉLECTRODES ET SON PROCÉDÉ DE FABRICATION

(30) Priority: 25.08.2017 US 201762550559 P
(43) Date of publication of application: 01.07.2020
(73) Proprietor: Watlow Electric Manufacturing Company, St. Louis, MO 63146 (US)
(72) Inventor: PARKER, Michael, Brentwood, CA 94513 (US)
(74) Representative: Boult Wade Tennant LLP
(86) International application number: PCT/US2018/047823
(87) International publication number: WO 2019/040794

(56) References cited:
- WO-A1-95/24070
- CN-A- 104 576 490
- US-A- 5 600 530
- US-A1- 2011 288 648
- US-A1- 2017 072 516

## Description

### FIELD OF THE INVENTION

This invention relates to semiconductor substrate supports, and more particularly to semiconductor substrate supports with an electrode.

### BACKGROUND OF THE INVENTION

Semiconductor support structures with multiple chucking electrodes may be used in support of semiconductor processing and in other industrial applications. Prior methods for making such pieces are costly and time intensive. US 5,600,530 describes an electrostatic chuck with first and second ceramic layers and a joining layer between them. The joining layer may be present only in some areas, with portions left empty or filled with a dielectric filler. US 2011/288648 describes a ceramic to ceramic joint and methods for making such a joint. CN 104,576,490 describes a chuck manufacturing method.

The present invention provides a method for manufacturing an electrostatic chuck as set out in claim 1 and an electrostatic chuck as set out in claim 14. Further features of the invention are set out in the dependent claims.

### BRIEF DESCRIPTION OF THE DRAWINGS

FIG. 1 is cross-sectional view of one embodiment of a plate assembly of the present invention formed from a first ceramic layer joined to a second ceramic layer with a metal joining layer.
FIG. 2 is a plan view of one embodiment of a grind pattern of the present invention in a plate assembly of the present invention.
FIG. 3 is a perspective view of the grind pattern of FIG. 2 in the plate assembly of FIG. 2.
FIG. 4 is a drawing of the grind pattern of FIG. 2 in the plate assembly of FIG. 2.
FIG. 5 is a drawing of the plate assembly of FIG. 2 with a filled grind pattern of FIG. 2.
FIG. 6 is a perspective view of an embodiment of an electrostatic chuck of the present invention.
FIG. 7 is a partially exploded view of the electrostatic chuck of FIG. 6.
FIG. 8 is an exploded view of an embodiment of a plate assembly of an electrostatic chuck of the present invention.
FIG. 9 is a cross-sectional view of a lift pin hole in an embodiment of an electrostatic chuck of the present invention.
FIG. 10 is a cross-sectional view of a cooling gas hole in an embodiment of an electrostatic chuck of the present invention.
FIG. 11 is an underside view of a two electrode plate assembly of the present invention.

### DETAILED DESCRIPTION OF THE INVENTION

A semiconductor substrate support and a method for manufacturing a semiconductor substrate support are provided. The semiconductor substrate support can be of any suitable type, for example an electrostatic chuck. The semiconductor substrate support can include a first ceramic layer or plate joined to a second ceramic layer or plate with a metal joining layer in any suitable manner. The joined first and second ceramic layers or plates can optionally be referred to as a plate assembly. The first ceramic layer or plate can optionally be referred to as a bottom ceramic layer or plate. The second ceramic layer or plate can optionally be referred to as a top ceramic layer or plate. At least one groove can be formed or provided extending through the first ceramic layer or plate and through the metal joining layer to provide at least one electrode portion. The at least one groove can optionally form a plurality of distinct electrode portions formed from the metal joining layer. The at least one groove in at least the metal joining layer can optionally be filled with a suitable dielectric material to electrically isolate the at least one electrode portion. The suitable dielectric material can optionally isolate a plurality of electrode portions from each other. The at least one groove in the first ceramic layer or plate can optionally be filled any suitable dielectric material.

The first ceramic layer or plate can be of any suitable material. The first ceramic layer or plate can optionally be of a ceramic known to not be susceptible to diffusion by aluminum. The first ceramic layer or plate can optionally be of alumina. The first ceramic layer or plate can optionally be of aluminum oxide. The first ceramic layer or plate can optionally be of sapphire. The first ceramic layer or plate can optionally be of beryllia. The first ceramic layer or plate can optionally be of zirconia. The first ceramic plate can optionally be of quartz. The second ceramic layer or plate can be of any suitable material. The second ceramic layer or plate can optionally be of a ceramic known to not be susceptible to diffusion by aluminum. The second ceramic layer or plate can optionally be of alumina. The second ceramic layer or plate can optionally be of aluminum oxide. The second ceramic layer or plate can optionally be of sapphire. The second ceramic layer or plate can optionally be of beryllia. The second ceramic layer or plate can optionally be of zirconia. The second ceramic plate can optionally be of quartz. The first and second ceramic layers or plates can be of the same ceramic material or of different ceramic materials, each layer or plate being of any suitable ceramic material including any of the ceramic materials listed in this paragraph. Each of the first ceramic layer or plate and the second ceramic layer or plate can optionally be circular, for example when viewed in plan. The first and second ceramic layers or plates can optionally have the same or different thicknesses.

Each of the first ceramic layer or plate and the second ceramic layer or plate can optionally have a joining surface, and the metal joining layer can optionally engage the joining surface of each ceramic layer or plate for joining the first ceramic layer or plate to the second ceramic layer or plate.

Any suitable metal material can be used for the joining layer, for example for engaging the joining surface of each of the first and second ceramic layers or plates. Aluminum can optionally be used for the joining layer. The aluminum of a joining layer can be of any suitable weight. For example, a joining layer of aluminum may optionally be of aluminum of greater than 89% by weight. A joining layer of aluminum may optionally be of aluminum of greater than 92% by weight. A joining layer of aluminum may optionally be of aluminum of greater than 98% by weight. A joining layer of aluminum may optionally be of aluminum of greater than 99% by weight. A joining layer of aluminum may optionally be of aluminum of greater than 99.5% by weight. A joining layer of aluminum may optionally be of aluminum of greater than 99.99% by weight. The aluminum of the joining layer may be referred to as metallic aluminum or a metal comprising aluminum.

Each of the first ceramic layer or plate and the second ceramic layer or plate can be optionally pre-metallized, for example on its respective joining surface, with a layer of the metal joining material. The metal can optionally be aluminum, including any of the high purity aluminums disclosed above. For example, each of the first and second ceramic layers or plates can be optionally pre-metallized with a layer of aluminum having a thickness in the range of 10-15 micrometres. Each of the first and second ceramic layers or plates can be optionally pre-metallized with a layer of aluminum having a thickness in the range of 10-20 micrometres. Each of the first and second ceramic layers or plates can be optionally pre-metallized with a layer of aluminum having a thickness in the range of 12.5-15 micrometres. Each of the first and second ceramic layers or plates can be optionally pre-metallized with a layer of aluminum having a thickness of greater than 10 micrometres. The metal layers on the first ceramic layer or plate and the second ceramic layer or plate may optionally form the entirety of the metal which forms the joining layer. A metal joining layer of other than aluminum can optionally have any of such same thicknesses.

Only one of the first ceramic layer or plate and the second ceramic layer or plate can be pre-metallized with a layer of metal. The metal can optionally be aluminum, including any of the high purity aluminums disclosed above. For example, one of the first and second ceramic layers or plates can be optionally pre-metallized with a layer of aluminum having a thickness in the range of 20-30 micrometres. One of the first and second ceramic layers or plates can be optionally pre-metallized with a layer of aluminum having a thickness of greater than 20 micrometres. one of the first and second ceramic layers or plates can be optionally pre-metallized with a layer of aluminum having a thickness in the range of 20-50 micrometres. The metal layer on either the first ceramic layer or plate or the second ceramic layer or plate may form the entirety of the metal which forms the joining layer.

A portion of the metal joining layer can optionally be sputtered on to one or both of the first and second ceramic layers or plates. For example, 12.5 micrometres or any other suitable thickness of aluminum can optionally be sputtered on to each of the first ceramic layer or plate and on to the second ceramic layer or plate.

The metal joining layer may optionally be formed by a suitable braze material. The braze material may optionally be a sheet. The braze material may optionally be a powder. The braze material may optionally be a thin film. The braze material may optionally be any other form factor suitable for the brazing processes described herein. Where the braze material is a sheet, the sheet may optionally have a thickness ranging from 0.00019 to 0.011 inch (4.826 micrometres to 279.4 micrometres) or more. The sheet may optionally have a thickness of approximately 0.0012 inch (30.48 micrometres). The sheet may optionally have a thickness of approximately 0.006 inch (152.4 micrometres).

The plate assembly can be heated to any suitable temperature for causing the metal joining layer to join the first ceramic layer or plate to the second ceramic layer or plate. For example, the plate assembly can optionally be heated to a joining temperature of at least 770°C. The plate assembly can optionally be heated to a joining temperature of at least 800°C. The plate assembly can optionally be heated to a joining temperature in the range of 770°C to 1200°C. The plate assembly can optionally be heated to a joining temperature in the range of 1100°C. The plate assembly can optionally be heated to a joining temperature in the range of 800°C to 1200°C.

The joining atmosphere, that is the atmosphere for joining the first ceramic layer or plate to the second ceramic layer or plate with the metal joining layer, can be of any suitable type. For example, the joining atmosphere can optionally be non-oxygenated. The joining may optionally occur in any suitable vacuum, for example in a vacuum with a pressure lower than 1 × 10E-4 Torr (0.0133 Pa) or in a vacuum with a pressure lower than 1 × 10E-5 Torr (0.00133 Pa). Further oxygen removal may optionally be achieved with the placement of zirconium or titanium in the joining atmosphere. Atmospheres other than vacuum may optionally be used. For example, an argon (Ar) atmosphere may optionally be used. Other noble gasses may optionally be used. Hydrogen (H₂) atmosphere may optionally be used.

A process for forming a metal joint of aluminum between the first and second ceramic layers or plates may optionally be free of diffusion bonding. In a process for forming a metal j oint of aluminum, the aluminum may wet the joining surfaces of each of the first and second ceramic layers or plates.

After joinder, the first and second ceramic layers or plates optionally have a layer of aluminum, or other suitable metal, between them which joins them with a hermetic seal. A metal joint of aluminum may optionally have a thickness greater than zero. Where the joint between the first and second ceramic layers or plates is an aluminum joint, the first and second ceramic layers and plates may optionally be free of diffusion of the aluminum joining material.

The at least one groove can optionally be a plurality of grooves. The at least one groove or plurality of grooves can optionally be referred to as an exclusion pattern. Each groove can optionally be referred to as a recess or slot, for example a recess or slot in the first ceramic layer or plate and in the metal joining layer. The at least one groove can be formed in any suitable manner, for example by machining or grinding. The at least one grooves is optionally wide enough such that the dielectric barrier created by the dielectric material in the at least one groove is sufficient for the target application, for example the amount of electrical charge in the one or more electrode portions or electrodes. The at least one groove can optionally include a circular groove for precisely defining the outer periphery of the one or more electrodes.

The dielectric material can be of any suitable type, and my optionally be referred to as a filler. For example, the dielectric material can optionally be a high dielectric effect epoxy. The dielectric material can optionally be a high dielectric strength high thermal conductivity elastomer. The dielectric material may optionally be magnesium oxide, which can optionally be covered with a suitable glass such as fiberglass. Each electrode portion can optionally be referred to as an electrode. The at least one groove can optionally be filled with solid pieces, for example thin strips, of the same ceramic as the ceramic of one or both of the first and second ceramic layers or plates, which may optionally be bonded in with a high dielectric effect epoxy.

Suitable electrical connectors, for example conductive leads, may optionally extend to the one or more electrodes. For example, at least one electrical connector can extend to each electrode portion or electrode. The suitable electrical connectors may optionally extend through the first ceramic layer or plate to the one or more electrode portions or electrodes.

The second ceramic layer or plate can optionally have a surface opposite the joining surface for supporting a semiconductor substrate. After the filling step, the second ceramic layer or plate, for example at least the portion overlying the one or more electrodes, can optionally be reduced or thinned to any suitable thickness, for example to increase or enhance the electrostatic attraction or clamping of the one or more electrode portions or electrodes. The high planarity and preciseness in placement in the ceramic assembly of the one or more electrode portions or electrodes can permit such reduction in thickness. The filling material, for example the suitable dielectric material, can enhance the rigidity of the plate assembly to facilitate such reduction in thickness. The thickness of the second ceramic plate overlying the metal joining layer, or the one or more electrodes formed by the metal joining layer, can optionally be reduced or thinned to a thickness of less than 0.015 inch (381 micrometres). The thickness of the second ceramic plate overlying the metal joining layer, or the one or more electrodes formed by the metal joining layer, can optionally be reduced or thinned to a thickness in the range of 0.010 to 0.012 inch (254 micrometres to 304.8 micrometres). The thickness of the second ceramic plate overlying the metal joining layer, or the one or more electrodes formed by the metal joining layer, can optionally be reduced or thinned to a thickness in the range of 0.005 to 0.015 (127 micrometres to 381 micrometres). The thickness of the second ceramic plate overlying the metal joining layer, or the one or more electrodes formed by the metal joining layer, can optionally be reduced or thinned to a thickness in the range of 0.005 to 0.010 inch (127 micrometres to 254 micrometres). The thickness of the second ceramic plate overlying the metal joining layer, or the one or more electrodes formed by the metal joining layer, can optionally be reduced or thinned to a thickness of 0.006 inch (152.4 micrometres). The thickness of the second ceramic plate overlying the metal joining layer, or the one or more electrodes formed by the metal joining layer, can optionally be reduced or thinned to a thinner thickness.

The embodiments of the invention set forth herein, for example below, are examples of the said invention which is defined by the appended claims.

A method for manufacturing an electrostatic chuck with multiple chucking electrodes made of ceramic pieces using metallic aluminum as the joining material is optionally provided. The aluminum may be placed between first and second ceramic pieces and the assembly of the ceramic pieces and the joining aluminum may be heated in the range of 770°C to 1200°C. The joining atmosphere may be non-oxygenated. After joinder, the exclusions in the electrode pattern may be machined by also machining through one of the ceramic pieces, which can be referred to as plate layers. The machined exclusion slots may then be filled with epoxy or any other suitable material. An electrostatic chuck, semiconductor substrate support or other structure can be manufactured according to such method.

A method for manufacture of an electrostatic chuck with multiple chucking electrodes is optionally provided and begins with the joining of two plates. The two plates are optionally circular plates and are optionally of a ceramic. The two plates can optionally be circular plates and optionally be of a ceramic known to not be susceptible to diffusion by aluminum. The optional ceramic material of the plates can be of any suitable type, including alumina, aluminum nitride, sapphire, beryllium oxide, or zirconia. One or both of the plates can optionally be of quartz.

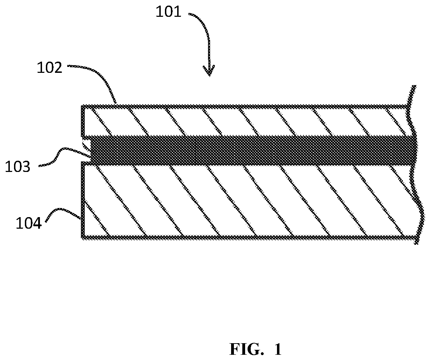

FIG. 1 is a partial cross-sectional view of an optional assembly 101 according to the present invention. A ceramic top layer 102 is joined to a ceramic bottom layer 104 with a joining layer 103. The joining layer 103 can optionally be used to join the top layer 102 to the bottom layer 104 and then also to function as one or more chucking electrodes. Although the joining layer 103 is illustrated in FIG. 1 as going nearly to the edge of the top ceramic layer 102, there optionally may be an electrical decoupling of the outer circumferential portion of the joining layer. The ceramic top layer 102 can optionally be of alumina, aluminum nitride, sapphire, beryllium oxide, or zirconia. The ceramic bottom layer 104 can optionally be of alumina, aluminum nitride, sapphire, beryllium oxide, or zirconia. the joining layer can optionally be of aluminum. The joining layer can optionally be a metal layer of aluminum of greater than 89% by weight. The joining layer can optionally be a metal layer of aluminum of greater than 99% by weight. The joining layer can optionally be a metal layer of aluminum of greater than 99.99% by weight.

For example, two ceramic plated discs can be alumina and can optionally be 0.125 inch (3175 micrometres) thick each. Each alumina disc can optionally be sputtered with 12.5 microns of aluminum. The plates can optionally be then brazed according to any of the processes described herein. The plates can optionally be pressed together with approximately 2 psi (13789.5 Pa) of contact pressure and brazed at 850°C under vacuum with a pressure lower than 1 × 10E-4 Torr (0.0133 Pa). The brazed assembly may be seen in partial cross-section in FIG. 1, where for example the first and second ceramic layers or plates are shown as having differing thicknesses. The first and second ceramic layers or plates can optionally have the same thickness.

Both the ceramic top layer and the ceramic bottom layer can optionally be pre-metallized with a layer of metal. The metal can optionally be high purity aluminum. Each layer can optionally be pre-metallized with an aluminum layer with a thickness in the range of 10-15 micrometres. Each layer can optionally be pre-metallized with an aluminum layer with a thickness in the range of 10-20 micrometres. Each layer can optionally be pre-metallized with an aluminum layer with a thickness in the range of 12.5-15 micrometres. Each layer can optionally be pre-metallized with an aluminum layer with a thickness of greater than 10 micrometres. The metal layers on the ceramic top layer and the ceramic bottom layer may optionally form the entirety of the metal which forms the joining layer.

Only one of the ceramic top layer and the ceramic bottom layer can optionally be pre-metallized with a layer of metal. The metal can optionally be high purity aluminum. One of the layers can be optionally pre-metallized with an aluminum layer having a thickness in the range of 20-30 micrometres. One of the layers can be optionally pre-metallized with an aluminum layer having a thickness of greater than 20 micrometres. One of the layers can be optionally pre-metallized with an aluminum layer having with a thickness in the range of 20-50 micrometres. The metal layer on either the ceramic top layer and the ceramic bottom layer may optionally form the entirety of the metal which forms the joining layer.

After brazing, the two circular plates optionally have a circular disc of aluminum between them which joins them with a hermetic seal. An exclusion pattern may optionally be machined into the aluminum layer by machining through one of the plates, for example the bottom plate, and then through the aluminum layer. The machining can optionally be done using ultrasonic milling and can optionally continue into the other plate, for example the top plate, a suitable distance, for example approximately 0.001 inch (25.4 micrometres). The machining can be done through the bottom ceramic layer or plate, and then also through the joining layer.

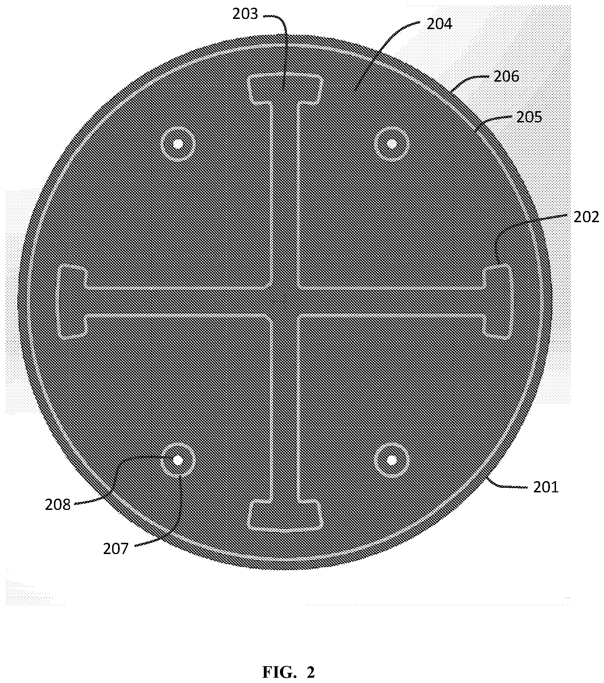

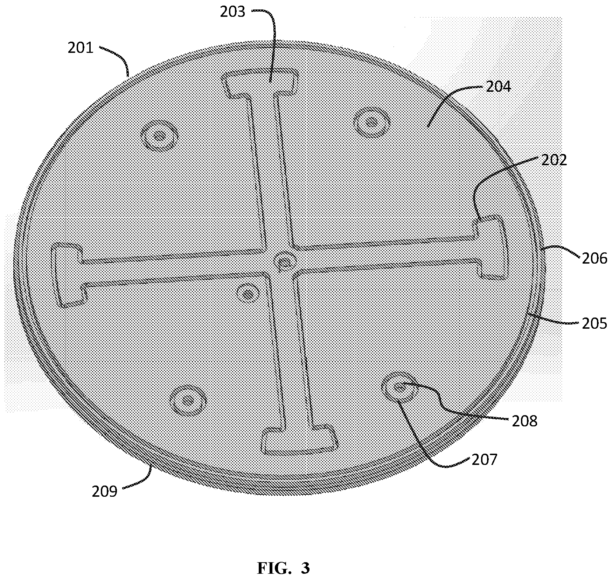

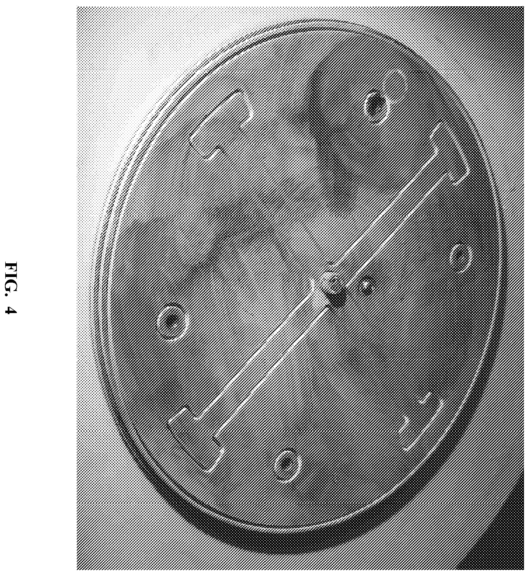

FIGS. 2, 3, and 4 illustrate an optional embodiment of the exclusion pattern and the machining done through the plate, the aluminum or other joining layer, and also partially into the second plate for a bipolar electrostatic chuck. FIGS. 2 and 3 illustrate the machining done through the ceramic bottom layer 201. At this stage of process of making the completed assembly, the exclusion pattern has been completed, but the filling of the exclusions has not yet occurred, nor has the final machining occurred. An electrode pattern splitting groove 202 splits the electrode formed by the metal joining layer into an interior electrode area 203, which is cross-shaped in an optional embodiment, and an exterior electrode area 204. The electrode pattern splitting groove 202 is machined through the ceramic bottom plate 201 and through the joining layer and just into the ceramic top layer 209. An outer groove 205 optionally decouples an outer periphery portion 206 from the exterior electrode area 204. The outer groove 205 also then electrically decouples an outer annular ring of the joining layer from the electrode portion of the joining layer. Also seen are optional lift pin grooves 207 which can electrically decouple the electrode from the joining layer which resides just around the lift pin through holes 208. FIG. 4 is a photograph of an actual assembly of the type illustrated in FIGS. 2 and 3. The grooves may optionally be as narrow as 0.063 inch (1600.2 micrometres) wide. One or more of the grooves are optionally wide enough such that the dielectric barrier created by the dielectric material in the one or more grooves is sufficient for the target application. Although illustrated as a two electrode device in this optional embodiment, there may optionally be more than two electrode portions or electrodes formed form the metal joining layer. Alternatively, there may optionally be a single electrode portion or electrode.

The exclusion pattern in the aluminum layer can optionally be mirrored with a void in the plate through which the machining was carried out. The void can then optionally be filled with a filler, such as a high dielectric effect epoxy. The filler may optionally be a high dielectric strength high thermal conductivity elastomer. The filler may optionally be magnesium oxide and then covered with glass such as fiberglass. The voids can optionally be filled with solid pieces of dielectric material, which may be bonded in with a high dielectric effect epoxy. The voids may optionally be filled with solid pieces of the same ceramic as the plate layers, which may optionally be bonded in with a high dielectric effect epoxy.

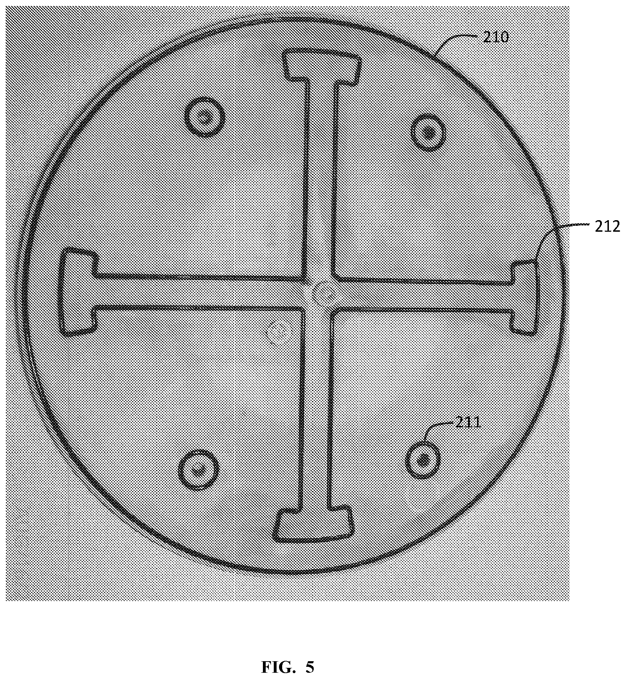

FIG. 5 is a photograph of an optional plate assembly at a later stage of completion. The electrode splitting groove 202 has been filled 212 with a high dielectric effect epoxy. The outer groove 205 has been filled 210 with a high dielectric effect epoxy. The lift pin grooves 207 have been filled 211 with a high dielectric effect epoxy. The grooves may optionally be filled with solid pieces of dielectric material, which may be bonded in with a high dielectric effect epoxy.

The back filled plate, for example the first ceramic layer or plate, may then be optionally planarized so that the surface through which the filler was placed can be made flat. After the filling of the voids, the plate through which the machining was not done, which may become a top ceramic layer or plate, may optionally be machined down to a thinner thickness to complete the ceramic plate assembly. For example, the top plate may optionally be machined down to the range of 0.010 to 0.012 inch (254 micrometres to 304.8 micrometres), or other thinner thickness. The top plate thickness may optionally be in the range of 0.005 to 0.015 inch (127 micrometres to 381 micrometres). The top plate thickness may optionally be in the range of 0.005 to 0.010 inch (127 micrometres to 254 micrometres). The top plate may optionally be thinned down to a thickness of 0.006 inch (152.4 micrometres). With the placement of the filler material underneath the top layer in the exclusion zones of the electrode pattern, there is support for the top layer as the machining thins down the top plate. Without such support, machining down to such a thin top plate may result in cracking or other damage to the top plate due to deflection of the plate during machining.

The completed electrostatic chuck may optionally be able to withstand 10,000V without cross talk.

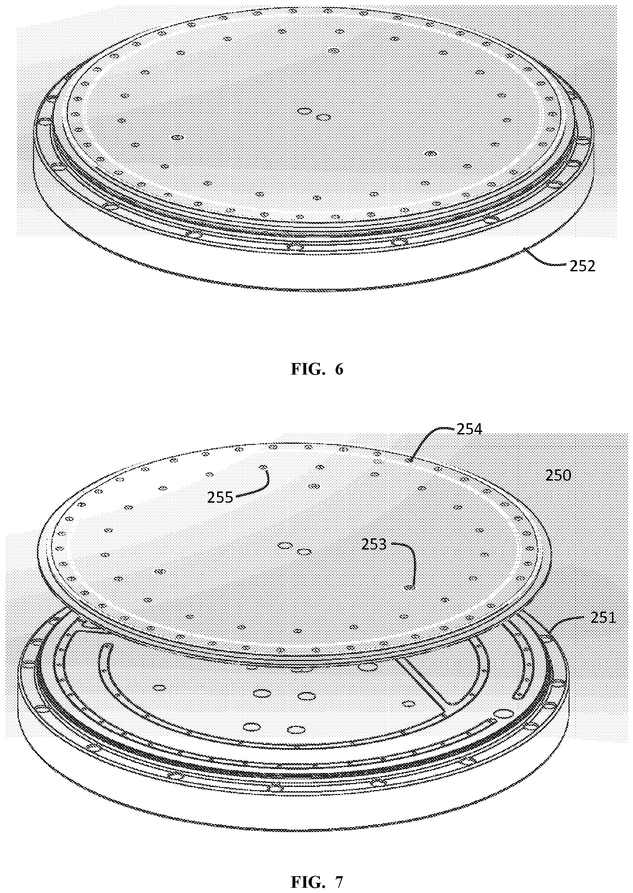

FIGS. 6 and 7 illustrate a view and an exploded view, respectively, of an optional embodiment of an electrostatic chuck 252 of the present invention. A ceramic plate assembly 250 comprising a ceramic top layer, a metal joining layer, and a ceramic bottom layer, can optionally be affixed to a base 251. The base 251 may optionally be of metal, which may optionally be aluminum. The base 251 may optionally include gas plenums which route gas into gas holes 254, 255 in the ceramic plate assembly 250. The ceramic plate assembly 250 may optionally include lift pin holes 253. The ceramic top layer optionally be so thin that the exclusion pattern in the metal joining layer and the metal joining layer may be visible through the top surface of the ceramic plate assembly.

Optional braze material may for optionally forming the metal joining layer may optionally be in the form of a sheet, a powder, a thin film, or be of any other form factor suitable for the brazing processes described herein. For example, the brazing layer may optionally be a sheet having a thickness ranging from 0.00019 inch (4.826 micrometres) to 0.011 inch (279.4 micrometres) or more. The braze material may optionally be a sheet having a thickness of approximately 0.0012 inch (30.48 micrometres). The braze material may optionally be a sheet having a thickness of approximately 0.006 inch (152.4 micrometres). The braze material may optionally be aluminum having a purity of at least 99.5 %. A commercially available aluminum foil, which may have a purity of greater than 92%, may optionally be used. Alloys may optionally be used. These alloys may optionally include A1-5w%Zr, A1-5w%Ti, commercial alloys #7005, #5083 or #7075. These alloys may optionally be used with a joining temperature of 1100°C. These alloys may optionally be used with a joining temperature between 800°C and 1200°C. These alloys may optionally be used with a lower or higher temperature. The aluminum joining layer may optionally be formed from pre-deposited layers on one or more of the ceramic layers or plates, as described above.

Typically, alloying constituents (such as magnesium, for example) in aluminum are formed as precipitates in between the grain boundaries of the aluminum. While they can reduce the oxidation resistance of an aluminum bonding layer, typically these precipitates do not form contiguous pathways through the aluminum, and thereby do not allow penetration of the oxidizing agents through the full aluminum layer, and thus leaving intact the self-limiting oxide-layer characteristic of aluminum which provides its corrosion resistance. Optional embodiments using an aluminum alloy which contains constituents which can form precipitates, process parameters, including cooling protocols, can optionally be adapted to minimize the precipitates in the grain boundary.

The non-susceptibility of aluminum nitride (AlN) to diffusion with aluminum under the conditions of processes according to the present invention may optionally result in the preservation of the material properties, and the material identity, of the ceramic after the brazing step in the manufacturing of the plate and shaft assembly.

The joining process may optionally be performed in a process chamber adapted to provide very low pressures. Joining processes of the invention may optionally require an absence of oxygen in order to achieve a hermetically sealed joint. The process may optionally be performed at a pressure lower than 1 × 10E-4 Torr (0.0133 Pa). The process may optionally be performed at a pressure lower than 1 × 10E-5 Torr (0.00133 Pa). Further oxygen removal may optionally be achieved with the placement of zirconium or titanium in the process chamber. For example, a zirconium inner chamber may optionally be placed around the pieces which are to be joined.

Atmospheres other than vacuum may optionally be used to achieve a hermetic seal. For example, an argon (Ar) atmosphere may optionally be used to achieve hermetic joints. Other noble gasses may optionally be used to achieve hermetic joints. Hydrogen (H₂) atmosphere may optionally be used to achieve hermetic joints.

The wetting and flow of the brazing layer may be sensitive to a variety of factors. The factors of concern include the braze material composition, the ceramic composition, the chemical makeup of the atmosphere in the process chamber, especially the level of oxygen in the chamber during the joining process, the temperature, the time at temperature, the thickness of the braze material, the surface characteristics of the material to be joined, the geometry of the pieces to be joined, the physical pressure applied across the joint during the joining process, and/or the joint gap maintained during the joining process.

An example of a brazing method for optionally joining together first and second ceramic objects may include the steps of bringing the first and second objects together with a brazing layer selected from the group consisting of aluminum and an aluminum alloy disposed between the first and second ceramic objects, heating the brazing layer to a temperature of at least 800°C, and cooling the brazing layer to a temperature below its melting point so that the brazing layer hardens and creates a hermetic seal so as to join the first member to the second member. Various geometries of braze joints may be implemented according to methods described herein. The joining layer may optionally be of aluminum of greater than 99% by weight aluminum, and the joining temperature may optionally be a temperature of at least 770°C. The joining layer may optionally be of aluminum of greater than 99% by weight aluminum, and the joining temperature may optionally be a temperature in the range of 770°C to 1200°C.

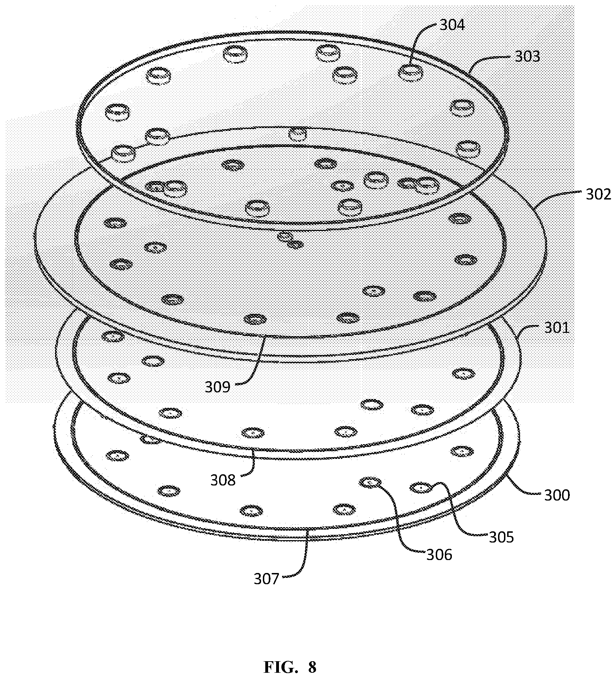

FIG. 8 illustrates an exploded view of an optional monopolar electrostatic chuck plate assembly of the present invention. In this illustrative view, what will become the top layer of a chuck is seen on the bottom. The ceramic top layer 300 is separated from the ceramic bottom layer 302 by the joining layer 301. The joining layer 301 joins the top and bottom ceramic layers and also functions as an electrode, or as multiple electrodes if split, after the manufacturing process is complete. The ceramic bottom layer 302 is seen with an outer groove 309, which goes through the ceramic bottom layer 302. The electrode 301 is seen with an outer groove 308, which extends through the electrode layer 301. The ceramic top layer 300 is seen with an outer groove 307, which enters only partially to a shallow depth in the ceramic top layer 300. The other illustrated grooves, for example the ring grooves 305 around the cooling gas holes, and the lift pin grooves 306 around the lift pin holes, similarly extend through the ceramic bottom layer, the electrode layer, and on partially into the ceramic top layer. Dielectric material portions of any suitable type serve as fillers and are placed into the various grooves described above. For example, the dielectric material portions may optionally be thin strips of the dielectric material, which may optionally be circular in shape. The outer ring dielectric portion 303 will reside in the outer ring groove within the ceramic bottom layer, the electrode layer, and a portion of the ceramic top layer. The ring dielectric portions 304 will reside in the lift pin and cooling gas ring grooves within the ceramic bottom layer, the electrode layer, and a portion of the ceramic top layer. The ceramic bottom layer may optionally be a ceramic from the group of alumina, aluminum nitride, beryllia, zirconia, and sapphire. The ceramic top layer may optionally be a ceramic from the group of alumina, aluminum nitride, beryllia, zirconia, and sapphire. The joining layer may optionally be of aluminum, for example as described herein.

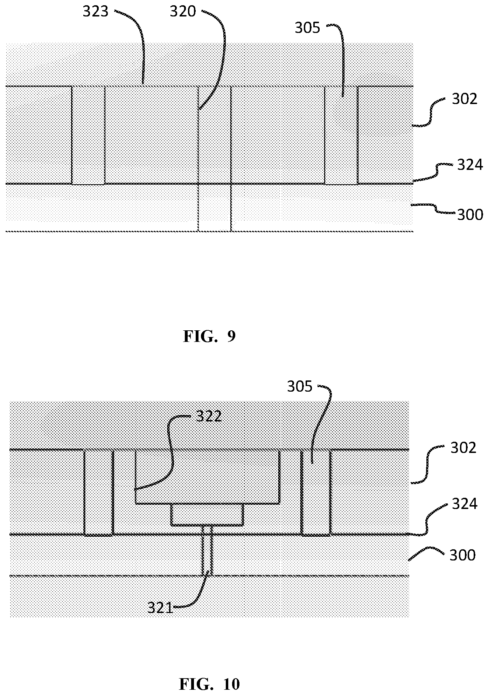

FIGS. 9 and 10 illustrate cross-section views of an optional lift pin hole and an optional cooling gas hole, respectively, of the present invention. FIG. 8 illustrates a partial cross-section in the area of an optional lift pin hole. Lift pin ring grooves 306 have been machined through the ceramic bottom layer 302 and through the electrode layer 324, and just partially into the ceramic second or top layer 300. The lift pin through hole 320 extends through the ceramic first or bottom layer, the metal joining electrode layer, and the ceramic second or top layer. The ceramic bottom layer remains 323 outside the lift pin through hole 320 and within the lift pin ring groove 306. FIG. 9 illustrates a partial cross-section in the area of an optional cooling gas hole 321. Cooling gas ring grooves 305 have been machined through the ceramic bottom layer 302 and through the electrode layer 324, and just partially into the ceramic top layer 300. The cooling gas through hole 321 extends through the ceramic bottom layer, the metal joining electrode layer, and the ceramic top layer. The ceramic bottom layer is optionally shaped 322 to allow for cooling gas access through the cooling gas hole 321 through the layers including the ceramic top layer.

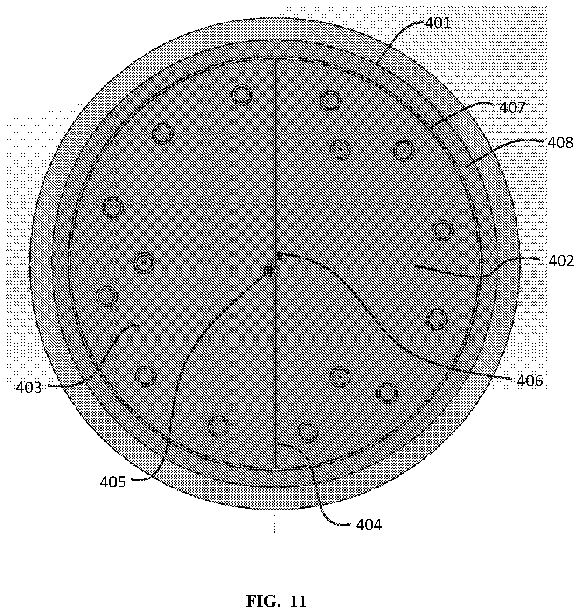

FIG. 11 illustrates an optional two zone electrostatic chuck assembly of the present invention. This illustrative figure shows aspects of the metal layer 401, although one could not see the layer. A first electrode portion 403 is seen split from a second electrode portion 402 by a splitting area 404. An outer ring groove 407 isolates an outer ring portion 408 from the electrode portions 402, 403. Electrical connections to the electrodes may be made at attachment areas 405, 406.

A joining process of the invention may optionally comprise some or all of the following steps. Two or more ceramic pieces are selected for joining. A plurality of pieces may optionally be joined using a plurality of joining layers in the same set of process steps, but for the sake of clarity of discussion two ceramic pieces joined with a single joining layer are be discussed herein. The ceramic pieces may optionally be of alumina. The ceramic pieces may optionally be of aluminum nitride. The ceramic pieces may optionally be of mono-crystalline or poly-crystalline aluminum nitride. The ceramic pieces may optionally be of alumina, aluminum nitride, beryllia, zirconia, or sapphire. Portions of each piece are identified as the area of each piece that will be joined to the other piece. In an illustrative example, a ceramic top layer is to be joined to a ceramic bottom layer. The joining material may optionally be a brazing layer comprising aluminum of greater than 99% aluminum content. The specific surface areas which will be joined may optionally undergo a pre-metallization step. This pre-metallization step may be achieved in a variety of ways. Physical vapor deposition (PVD), chemical vapor deposition (CVD), electro-plating, plasma spray, or other methods may optionally be used to apply the pre-metallization.

Prior to joining, the two pieces may optionally be fixtured relative to each other to maintain some positional control while in the process chamber. The fixturing may also aid in the application of an externally applied load to create contact pressure between the two pieces, and across the joint, during the application of temperature. A weight may optionally be placed on top of the fixture pieces such that contact pressure in applied across the joint. The weight may optionally be proportioned to the area of the brazing layer. The contact pressure applied across the joint may optionally be in the range of approximately 2-500 psi (1.379 × 10⁴ - 3.447 × 10⁶ Pa) onto the joint contact areas. The contact pressure may optionally be in the range of 2-40 psi (1.379 × 10⁴ - 2.758 × 10⁵ Pa). Minimal pressure may optionally be used. The contact pressure used at this step may optionally be significantly lower than that seen in the joining step using hot pressing/sintering as seen in prior processes, which may optionally use pressures in the range of 2000-3000 psi (1.379 × 10⁷ Pa-2.068 × 10⁷ Pa). The plates may optionally be pressed together with approximately two psi of contact pressure and joined at 850°C under vacuum with a pressure lower than 1 × 10E-4 Torr (0.0133 Pa). The plates may be optionally joined at a temperature of greater than 770°C. The plates may optionally be joined at a temperature in the range of 770°C to 1200°C.

After brazing, the two circular plates may optionally have a circular disc of aluminum placed between them so as to join them together with a hermetic seal. An exclusion pattern may optionally be machined into the aluminum layer by machining through one of the plates and then through the aluminum layer. The machining may optionally be done using ultrasonic milling and optionally continues into the other plate approximately 0.001 inch (25.4 micrometres). The machining may optionally be done through the bottom ceramic layer, and then also through the joining layer.

The exclusion pattern in the aluminum layer may optionally be mirrored with a void in the plate through which the machining was carried out. The void may optionally be then filled with a filler, such as a high dielectric effect epoxy. The filler may optionally be magnesium oxide and then covered with glass such as fiberglass. The voids may optionally be filled with solid pieces of dielectric material, which may optionally be bonded in place with a high dielectric effect epoxy.

The back filled plate may optionally be planarized so that the surface through which the filler was placed can be made flat. After the filling of the voids, the plate through which the machining was not done, which may become a top plate, may optionally be machined down to a thinner thickness. For example, the top plate may optionally be machined down to the range of 0.010 to 0.012 inch (254 micrometres to 304.8 micrometres), or other thinner thickness. The top plate may optionally be thinned down to a thickness of 0.006 inch (152.4 micrometres). The placement of the filler material underneath the top layer in the exclusion zones of the electrode pattern can serve as a support for the top layer as the machining thins down the top plate.

The method for manufacturing an electrostatic chuck can be provided, and comprise joining a first ceramic plate to a second ceramic plate with a metal joining layer, forming at least one groove extending through the first ceramic plate and through the metal joining layer to provide at least one electrode portion formed from the metal joining layer and filling the at least one groove in at least the metal joining layer with a dielectric material to electrically isolate the at least one electrode portion.

The at least one of the first ceramic plate and the second ceramic plate can optionally be formed from alumina. The at least one of the first ceramic plate and the second ceramic plate can optionally be formed from aluminum oxide. The at least one of the first ceramic plate and the second ceramic plate can optionally be formed from sapphire. The at least one of the first ceramic plate and the second ceramic plate can optionally be formed from beryllia. The at least one of the first ceramic plate and the second ceramic plate can optionally be formed from zirconia. Both the first ceramic plate and the second ceramic plate can optionally be formed from alumina. Both the first ceramic plate and the second ceramic plate can optionally be formed from aluminum oxide. Both the first ceramic plate and the second ceramic plate can optionally be formed from sapphire. Both the first ceramic plate and the second ceramic plate can optionally be formed from beryllia. Both the first ceramic plate and the second ceramic plate can optionally be formed from zirconia. The metal joining layer can optionally be aluminum greater than 89% aluminum by weight. The metal joining layer can optionally be aluminum greater than 92% aluminum by weight. The metal joining layer can optionally be aluminum greater than 99% aluminum by weight. The metal joining layer can optionally be aluminum greater than 99.5% aluminum by weight. The metal joining layer can optionally be aluminum greater than 99.99% aluminum by weight. The joining step can optionally include depositing a layer of aluminum onto a joining surface of the first ceramic plate, placing the layer of aluminum on the joining surface of the first ceramic plate onto a joining surface of the second ceramic plate to form a plate assembly and heating the plate assembly to a temperature greater than 770°C. The heating step can optionally include heating the plate assembly to a temperature greater than 770°C while at a pressure lower than 1 x10 E-4 Torr (0.0133 Pa). The heating step can optionally include heating the plate assembly to a temperature greater than 770°C while at a pressure lower than 1 ×10 E-5 Torr 0.00133 Pa). The filling step can optionally include filling the at least one groove in the first ceramic plate and the metal joining layer with a dielectric material to electrically isolate the at least one electrode. The filling step can optionally include filling the at least one groove in at least the metal joining layer with a high dielectric effect epoxy. The providing step can optionally include machining an exclusion pattern extending through the first ceramic plate and through the metal joining layer to provide at least one electrode portion formed from the metal joining layer. The machining step can optionally include machining an exclusion pattern which comprises a circumferential ring near an outer periphery of the first ceramic plate and said second ceramic plate. The joining step can optionally include joining a first ceramic plate to a second ceramic plate with a metal joining layer to form a plate assembly, further comprising reducing the thickness of the second ceramic plate overlying the metal joining layer after the filling step. The reducing step can optionally include machining the second ceramic plate overlying the metal joining layer to a thickness of less than 0.015 inch (381 micrometres). The forming step can optionally include forming at least one groove extending through the first ceramic plate and through the metal joining layer to provide a plurality of electrode portions formed from the metal joining layer and the filling step includes filling the at least one groove in at least the metal joining layer with a dielectric material to electrically isolate the plurality of electrode portions from each other.

An electrostatic chuck can be provided, and comprise a plate assembly formed from a first ceramic layer joined to a second ceramic layer with a metal joining layer, the plate assembly being provided with at least one groove extending through the first ceramic layer and through the metal joining layer to provide at least one electrode portion formed from the metal joining layer and a dielectric material disposed in the at least one groove in at least the metal joining layer so as to electrically isolate the at least one electrode portion.

The at least one of the first ceramic plate and the second ceramic plate can optionally be formed from alumina. The at least one of the first ceramic plate and the second ceramic plate can optionally be formed from aluminum oxide. The at least one of the first ceramic plate and the second ceramic plate can optionally be formed from sapphire. The at least one of the first ceramic plate and the second ceramic plate can optionally be formed from beryllia. The at least one of the first ceramic plate and the second ceramic plate can optionally be formed from zirconia. Both the first ceramic plate and the second ceramic plate can optionally be formed from alumina. Both the first ceramic plate and the second ceramic plate can optionally be formed from aluminum oxide. Both the first ceramic plate and the second ceramic plate can optionally be formed from sapphire. Both the first ceramic plate and the second ceramic plate can optionally be formed from beryllia. Both the first ceramic plate and the second ceramic plate can optionally be formed from zirconia. The metal joining layer can optionally be aluminum greater than 89% aluminum by weight. The metal joining layer can optionally be aluminum greater than 92% aluminum by weight. The metal joining layer can optionally be aluminum greater than 99% aluminum by weight. The metal joining layer can optionally be aluminum greater than 99.5% aluminum by weight. The metal joining layer can optionally be aluminum greater than 99.99% aluminum by weight. The second ceramic layer can optionally have a chucking surface. The second ceramic layer overlying the metal joining layer can optionally have a thickness of less than 0.015 inch (381 micrometres). The second ceramic layer overlying the metal joining layer can optionally have a thickness of 0.010 to 0.012 inch (254 to 304.8 micrometres). The second ceramic layer overlying the metal joining layer can optionally have a thickness of 0.005 to 0.015 inch (127 to 381 micrometres). The second ceramic layer overlying the metal joining layer can optionally have a thickness of 0.005 to 0.010 inch (127 to 254 micrometres). The second ceramic layer overlying the metal joining layer can optionally have a thickness of 0.006 inch (152.4 micrometres).

The invention is defined by the appended claims.

## Claims

1. A method for manufacturing an electrostatic chuck, comprising joining a first ceramic plate (201, 302) to a second ceramic plate (209, 300) with a metal joining layer (301), forming at least one groove (202, 308) extending through the first ceramic plate and through the metal joining layer to create at least one electrode portion (203) and a remainder portion (204) from the metal joining layer and filling the at least one groove in at least the metal joining layer with a dielectric material to electrically isolate the at least one electrode portion from the remainder portion;
**characterized in that** the forming step includes machining an exclusion pattern extending through the first ceramic plate and through the metal joining layer to create the at least one electrode portion and the remainder portion from the metal joining layer.

2. The method of Claim 1, wherein at least one of the first ceramic plate (201, 302) and the second ceramic plate (209, 300) is formed from a ceramic selected from the group consisting of alumina, aluminum oxide, sapphire, beryllia and zirconia.

3. The method of Claim 1, wherein both the first ceramic plate (201, 302) and the second ceramic plate (209, 300) are formed from a ceramic selected from the group consisting of alumina, aluminum oxide, sapphire, beryllia and zirconia.

4. The method of any of Claims 1 to 3, wherein the metal joining layer (301) is aluminum selected from the group consisting of aluminum greater than 89% aluminum by weight, aluminum greater than 92% aluminum by weight, aluminum greater than 99% aluminum by weight, aluminum greater than 99.5% aluminum by weight and aluminum greater than 99.99% aluminum by weight.

5. The method of any of Claims 1 to 3, wherein the joining step includes depositing a layer of aluminum onto a joining surface of the first ceramic plate (201, 302), placing the layer of aluminum on the joining surface of the first ceramic plate onto a joining surface of the second ceramic plate (209, 300) to form a plate assembly and heating the plate assembly to a temperature greater than 770°C.

6. The method of Claim 5, wherein the heating step includes heating the plate assembly to a temperature greater than 770°C while at a pressure lower than 1 ×10 E-4 Torr (0.0133 Pa).

7. The method of any of Claims 1 to 3, wherein the filling step includes filling the at least one groove (202, 308) in the first ceramic plate (201, 302) and the metal joining layer (301) with a dielectric material to electrically isolate the at least one electrode (203).

8. The method of any of Claims 1 to 3, wherein the filling step includes filling the at least one groove (202, 308) in at least the metal joining layer (301) with a high dielectric effect epoxy.

9. The method of any of Claims 1 to 8, wherein the machining of the exclusion pattern continues through the first ceramic plate (201, 302) and the metal joining layer and into the second ceramic plate (209, 300) .

10. The method of any of Claims 1 to 9, wherein the machining step includes machining an exclusion pattern which comprises a circumferential ring near an outer periphery of the first ceramic plate (201, 302) and said second ceramic plate (209, 300).

11. The method of any of Claims 1 to 3, wherein the joining step includes joining a first ceramic plate (201, 302) to a second ceramic plate (209, 300) with a metal joining layer (301) to form a plate assembly, further comprising reducing the thickness of the second ceramic plate (209, 300) overlying the metal joining layer after the filling step.

12. The method Claim 11, wherein the reducing step includes machining the second ceramic plate (209, 300) overlying the metal joining layer to a thickness of less than 0.015 inch (381 micrometres).

13. The method of any of Claims 1 to 3, wherein the forming step includes forming at least one groove extending through the first ceramic plate (201, 302) and through the metal joining layer to create a plurality of electrode portions formed from the metal joining layer and the filling step includes filling the at least one groove in at least the metal joining layer with a dielectric material to electrically isolate the plurality of electrode portions from each other.

14. An electrostatic chuck, comprising a plate assembly formed from a single first ceramic layer (201, 302) joined to a single second ceramic layer (209, 300) with a metal joining layer, the plate assembly being provided with at least one groove (202, 308) extending through the first ceramic layer and through the metal joining layer to create at least one electrode portion (203) and a remainder portion (204) from the metal joining layer and a dielectric material disposed in the at least one groove in at least the metal joining layer so as to electrically isolate the at least one electrode portion from the remainder portion, **characterized in that** the at least one groove (202, 308) is formed by an exclusion pattern which is machined through the first ceramic layer and through the metal joining layer.

15. The electrostatic chuck of Claim 14, wherein at least one of the first ceramic layer (201, 302) and the second ceramic layer (209, 300) is formed from a ceramic selected from the group consisting of alumina, aluminum oxide, sapphire, beryllia and zirconia.

16. The electrostatic chuck of Claim 14, wherein both the first ceramic layer (201, 302) and the second ceramic layer (209, 300) are formed from a ceramic selected from the group consisting of alumina, aluminum oxide, sapphire, beryllia and zirconia.

17. The electrostatic chuck of any of Claims 14 to 16, wherein the metal joining layer is aluminum selected from the group consisting of aluminum greater than 89% aluminum by weight, aluminum greater than 92% aluminum by weight, aluminum greater than 99% aluminum by weight, aluminum greater than 99.5% aluminum by weight and aluminum greater than 99.99% aluminum by weight.

18. The electrostatic chuck of any of Claims 14 to 16, wherein the second ceramic layer (209, 300) has a chucking surface, the second ceramic layer overlying the metal joining layer having a thickness selected from the group consisting of less than 0.015 inch (381 micrometres), 0.010 to 0.012 inch (254 to 304.8 micrometres), 0.005 to 0.015 inch (127 to 381 micrometres), 0.005 to 0.010 inch (127 to 254 micrometres) and 0.006 inch (152.4 micrometres).

19. The electrostatic chuck of any of claims 14 to 18, wherein the exclusion pattern continues through the first ceramic layer (201, 302) and the metal joining layer and into the second ceramic layer (209, 300).

## Patentansprüche

1. Verfahren zur Herstellung eines elektrostatischen Spannfutters, umfassend das Verbinden einer ersten Keramikplatte (201, 302) mit einer zweiten Keramikplatte (209, 300) über eine Metallverbindungsschicht (301), das Ausbilden mindestens einer Nut (202, 308), die sich durch die erste Keramikplatte und durch die Metallverbindungsschicht erstreckt, um aus der Metallverbindungsschicht mindestens einen Elektrodenabschnitt (203) und einen Restabschnitt (204) zu erzeugen, und das Füllen der mindestens einen Nut in mindestens der Metallverbindungsschicht mit einem dielektrischen Material, um den mindestens einen Elektrodenabschnitt von dem Restabschnitt elektrisch zu isolieren;
**dadurch gekennzeichnet, dass** der Schritt des Ausbildens das abtragende Herstellen eines Ausschlussmusters umfasst, das sich durch die erste Keramikplatte und durch die Metallverbindungsschicht hindurch erstreckt, um den mindestens einen Elektrodenabschnitt und den Restabschnitt aus der Metallverbindungsschicht zu erzeugen.

2. Verfahren nach Anspruch 1, bei dem die erste Keramikplatte (201, 302) und/oder die zweite Keramikplatte (209, 300) aus einer Keramik gebildet wird, die aus der Gruppe ausgewählt ist, die aus Aluminiumoxid, Aluminiumoxid, Saphir, Berylliumoxid und Zirkoniumoxid besteht.

3. Verfahren nach Anspruch 1, bei dem sowohl die erste Keramikplatte (201, 302) als auch die zweite Keramikplatte (209, 300) aus einer Keramik gebildet werden, die aus der Gruppe ausgewählt ist, die aus Aluminiumoxid, Aluminiumoxid, Saphir, Berylliumoxid und Zirkoniumoxid besteht.

4. Verfahren nach einem der Ansprüche 1 bis 3, bei dem die Metallverbindungsschicht (301) aus Aluminium besteht, das aus der Gruppe ausgewählt ist, die aus Aluminium mit mehr als 89 Gew.-% Aluminium, Aluminium mit mehr als 92 Gew.-% Aluminium, Aluminium mit mehr als 99 Gew.-% Aluminium, Aluminium mit mehr als 99,5 Gew.-% Aluminium und Aluminium mit mehr als 99,99 Gew.-% Aluminium besteht.

5. Verfahren nach einem der Ansprüche 1 bis 3, bei dem der Schritt des Verbindens das Aufbringen einer Aluminiumschicht auf eine Verbindungsfläche der ersten Keramikplatte (201, 302), das Aufbringen der Aluminiumschicht auf der Verbindungsfläche der ersten Keramikplatte auf eine Verbindungsfläche der zweiten Keramikplatte (209, 300), um eine Plattenanordnung zu bilden, und das Erhitzen der Plattenanordnung auf eine Temperatur von mehr als 770°C umfasst.

6. Verfahren nach Anspruch 5, bei dem der Schritt des Erhitzens das Erhitzen der Plattenanordnung auf eine Temperatur von mehr als 770°C bei einem Druck von weniger als 1 x10 E-4 Torr (0,0133 Pa) umfasst.

7. Verfahren nach einem der Ansprüche 1 bis 3, bei dem der Schritt des Füllens das Füllen der mindestens einen Nut (202, 308) in der ersten Keramikplatte (201, 302) und der Metallverbindungsschicht (301) mit einem dielektrischen Material umfasst, um die mindestens eine Elektrode (203) elektrisch zu isolieren.

8. Verfahren nach einem der Ansprüche 1 bis 3, bei dem der Schritt des Füllens das Füllen der mindestens einen Nut (202, 308) in mindestens der Metallverbindungsschicht (301) mit einem Epoxid mit hohem dielektrischen Effekt umfasst.

9. Verfahren nach einem der Ansprüche 1 bis 8, bei dem das abtragende Herstellen des Ausschlussmusters durch die erste Keramikplatte (201, 302) und die Metallverbindungsschicht hindurch und in die zweite Keramikplatte (209, 300) hinein erfolgt.

10. Verfahren nach einem der Ansprüche 1 bis 9, bei dem der Schritt des abtragenden Herstellens das abtragende Herstellen eines Ausschlussmusters umfasst, das einen umlaufenden Ring in der Nähe eines Außenumfangs der ersten Keramikplatte (201, 302) und der zweiten Keramikplatte (209, 300) umfasst.

11. Verfahren nach einem der Ansprüche 1 bis 3, bei dem der Schritt des Verbindens das Verbinden einer ersten Keramikplatte (201, 302) mit einer zweiten Keramikplatte (209, 300) mittels einer Metallverbindungsschicht (301) umfasst, um eine Plattenanordnung zu bilden, und ferner nach dem Schritt des Füllens das Verringern der Dicke der über der Metallverbindungsschicht liegenden zweiten Keramikplatte (209, 300) umfasst.

12. Verfahren nach Anspruch 11, bei dem der Schritt des Verringerns abtragendes Bearbeiten der über der Metallverbindungsschicht liegenden zweiten Keramikplatte (209, 300) auf eine Dicke von weniger als 0,015 Zoll (381 Mikrometer) umfasst.

13. Verfahren nach einem der Ansprüche 1 bis 3, bei dem der Schritt des Ausbildens das Ausbilden mindestens einer sich durch die erste Keramikplatte (201, 302) und durch die Metallverbindungsschicht erstreckenden Nut umfasst, um eine Mehrzahl von aus der Metallverbindungsschicht gebildeten Elektrodenabschnitten zu erzeugen, und der Schritt des Füllens das Füllen der mindestens einen Nut in mindestens der Metallverbindungsschicht mit einem dielektrischen Material umfasst, um die Mehrzahl von Elektrodenabschnitten voneinander elektrisch zu isolieren.

14. Elektrostatisches Spannfutter, umfassend eine Plattenanordnung, die aus einer einzelnen ersten Keramikschicht (201, 302) gebildet ist, die mit einer einzelnen zweiten Keramikschicht (209, 300) über eine Metallverbindungsschicht verbunden ist, wobei die Plattenanordnung mit mindestens einer Nut (202, 308) versehen ist, die sich durch die erste Keramikschicht und durch die Metallverbindungsschicht erstreckt, um mindestens einen Elektrodenabschnitt (203) und einen Restabschnitt (204) aus der Metallverbindungsschicht zu erzeugen, und wobei ein dielektrisches Material in der mindestens einen Nut in mindestens der Metallverbindungsschicht angeordnet ist, um den mindestens einen Elektrodenabschnitt von dem Restabschnitt elektrisch zu isolieren,
**dadurch gekennzeichnet, dass** die mindestens eine Nut (202, 308) durch ein Ausschlussmuster gebildet ist, das durch die erste Keramikschicht und durch die Metallverbindungsschicht hindurch abtragend hegestellt ist.

15. Elektrostatisches Spannfutter nach Anspruch 14, bei der die erste Keramikschicht (201, 302) und/oder die zweite Keramikschicht (209, 300) aus einer Keramik gebildet ist, die aus der Gruppe ausgewählt ist, die aus Aluminiumoxid, Aluminiumoxid, Saphir, Berylliumoxid und Zirkoniumoxid besteht.

16. Elektrostatisches Spannfutter nach Anspruch 14, bei der sowohl die erste Keramikschicht (201, 302) als auch die zweite Keramikschicht (209, 300) aus einer Keramik gebildet sind, die aus der Gruppe ausgewählt ist, die aus Aluminiumoxid, Aluminiumoxid, Saphir, Berylliumoxid und Zirkoniumoxid besteht.

17. Elektrostatisches Spannfutter nach einem der Ansprüche 14 bis 16, bei der die Metallverbindungsschicht Aluminium ist, das aus der Gruppe ausgewählt ist, die aus Aluminium mit mehr als 89 Gew.-% Aluminium, Aluminium mit mehr als 92 Gew.-% Aluminium, Aluminium mit mehr als 99 Gew.-% Aluminium, Aluminium mit mehr als 99,5 Gew.-% Aluminium und Aluminium mit mehr als 99,99 Gew.-% Aluminium besteht.

18. Elektrostatisches Spannfutter nach einem der Ansprüche 14 bis 16, bei dem die zweite Keramikschicht (209, 300) eine Spannfläche aufweist, wobei die zweite Keramikschicht, die über der Metallverbindungsschicht liegt, eine Dicke aufweist, die aus der Gruppe ausgewählt ist, die aus weniger als 0. 015 Zoll (381 Mikrometer), 0,010 bis 0,012 Zoll (254 bis 304,8 Mikrometer), 0,005 bis 0,015 Zoll (127 bis 381 Mikrometer), 0,005 bis 0,010 Zoll (127 bis 254 Mikrometer) und 0,006 Zoll (152,4 Mikrometer) besteht.

19. Elektrostatisches Spannfutter nach einem der Ansprüche 14 bis 18, bei dem sich das Ausschlussmuster durch die erste Keramikschicht (201, 302) und die Metallverbindungsschicht bis in die zweite Keramikschicht (209, 300) fortsetzt.

## Revendications

1. Procédé de fabrication d'un mandrin électrostatique, comprenant l'assemblage d'une première plaque en céramique (201, 302) à une deuxième plaque en céramique (209, 300) avec une couche d'assemblage métallique (301), la formation d'au moins une rainure (202, 308) s'étendant à travers la première plaque en céramique et à travers la couche d'assemblage métallique pour créer au moins une partie d'électrode (203) et une partie restante (204) à partir de la couche d'assemblage métallique et le remplissage de l'au moins une rainure dans au moins la couche d'assemblage métallique avec un matériau diélectrique pour isoler électriquement l'au moins une partie d'électrode de la partie restante ;
**caractérisé en ce que** l'étape de formation comprend l'usinage d'un motif d'exclusion s'étendant à travers la première plaque en céramique et à travers la couche d'assemblage métallique pour créer l'au moins une partie d'électrode et la partie restante à partir de la couche d'assemblage métallique.

2. Procédé de la revendication 1, dans lequel au moins l'une parmi la première plaque en céramique (201, 302) et la deuxième plaque en céramique (209, 300) est formée à partir d'une céramique choisie dans le groupe constitué par l'alumine, l'oxyde d'aluminium, le saphir, l'oxyde de béryllium et la zircone.

3. Procédé de la revendication 1, dans lequel la première plaque en céramique (201, 302) et la deuxième plaque en céramique (209, 300) sont toutes deux formées à partir d'une céramique choisie dans le groupe constitué par l'alumine, l'oxyde d'aluminium, le saphir, l'oxyde béryllium et la zircone.

4. Procédé de l'une des revendications 1 à 3, dans lequel la couche d'assemblage métallique (301) est de l'aluminium choisi dans le groupe constitué d'aluminium à plus de 89% d'aluminium en poids, d'aluminium à plus de 92% d'aluminium en poids, d'aluminium à plus de 99% d'aluminium en poids, d'aluminium à plus de 99,5% d'aluminium en poids et d'aluminium à plus de 99,99% d'aluminium en poids.

5. Procédé de l'une des revendications 1 à 3, dans lequel l'étape d'assemblage comprend le dépôt d'une couche d'aluminium sur une surface d'assemblage de la première plaque en céramique (201, 302), le placement de la couche d'aluminium sur la surface d'assemblage de la première plaque en céramique sur une surface d'assemblage de la deuxième plaque en céramique (209, 300) pour former un ensemble plaque et le chauffage de l'ensemble plaque à une température supérieure à 770°C.

6. Procédé de la revendication 5, dans lequel l'étape de chauffage comprend le chauffage de l'ensemble plaque à une température supérieure à 770°C tout en étant à une pression inférieure à 1 × 10 E-4 Torr (0,0133 Pa).

7. Procédé de l'une des revendications 1 à 3, dans lequel l'étape de remplissage comprend le remplissage de l'au moins une rainure (202, 308) dans la première plaque en céramique (201, 302) et la couche d'assemblage métallique (301) avec un matériau diélectrique pour isoler électriquement l'au moins une électrode (203).

8. Procédé de l'une des revendications 1 à 3, dans lequel l'étape de remplissage comprend le remplissage de l'au moins une rainure (202, 308) dans au moins la couche d'assemblage métallique (301) avec un époxy à effet diélectrique élevé.

9. Procédé de l'une des revendications 1 à 8, dans lequel l'usinage du motif d'exclusion se poursuit à travers la première plaque en céramique (201, 302) et la couche d'assemblage métallique et dans la deuxième plaque en céramique (209, 300).

10. Procédé de l'une des revendications 1 à 9, dans lequel l'étape d'usinage comprend l'usinage d'un motif d'exclusion qui comprend un anneau circonférentiel près d'une périphérie externe de la première plaque en céramique (201, 302) et de ladite deuxième plaque en céramique (209, 300) .

11. Procédé de l'une des revendications 1 à 3, dans lequel l'étape d'assemblage comprend l'assemblage d'une première plaque en céramique (201, 302) à une deuxième plaque en céramique (209, 300) avec une couche d'assemblage métallique (301) pour former un ensemble plaque, comprenant en outre la réduction de l'épaisseur de la deuxième plaque en céramique (209, 300) recouvrant la couche d'assemblage métallique après l'étape de remplissage.

12. Procédé de la revendication 11, dans lequel l'étape de réduction comprend l'usinage de la deuxième plaque en céramique (209, 300) recouvrant la couche d'assemblage métallique jusqu'à une épaisseur inférieure à 0,015 pouce (381 micromètres).

13. Procédé de l'une des revendications 1 à 3, dans lequel l'étape de formation comprend la formation d'au moins une rainure s'étendant à travers la première plaque en céramique (201, 302) et à travers la couche d'assemblage métallique pour créer une pluralité de parties d'électrode formées à partir de la couche d'assemblage métallique et l'étape de remplissage comprend le remplissage de l'au moins une rainure dans au moins la couche d'assemblage métallique avec un matériau diélectrique pour isoler électriquement la pluralité de parties d'électrode les unes des autres.

14. Mandrin électrostatique, comprenant un ensemble plaque formé à partir d'une seule première couche de céramique (201, 302) assemblée à une seule deuxième couche de céramique (209, 300) avec une couche d'assemblage métallique, l'ensemble plaque étant pourvu d'au moins une rainure (202, 308) s'étendant à travers la première couche de céramique et à travers la couche d'assemblage métallique pour créer au moins une partie d'électrode (203) et une partie restante (204) à partir de la couche d'assemblage métallique et un matériau diélectrique disposé dans l'au moins une rainure dans au moins la couche d'assemblage métallique de manière à isoler électriquement l'au moins une partie d'électrode de la partie restante, **caractérisé en ce que** l'au moins une rainure (202, 308) est formée par un motif d'exclusion qui est usiné à travers la première couche de céramique et à travers la couche d'assemblage métallique.

15. Mandrin électrostatique de la revendication 14, dans lequel au moins l'une parmi la première couche de céramique (201, 302) et la deuxième couche de céramique (209, 300) est formée à partir d'une céramique choisie dans le groupe constitué par l'alumine, l'oxyde d'aluminium, le saphir, l'oxyde de béryllium et la zircone.

16. Mandrin électrostatique de la revendication 14, dans lequel la première couche de céramique (201, 302) et la deuxième couche de céramique (209, 300) sont formées à partir d'une céramique choisie dans le groupe constitué par l'alumine, l'oxyde d'aluminium, le saphir, l'oxyde de béryllium et la zircone.

17. Mandrin électrostatique de l'une des revendications 14 à 16, dans lequel la couche d'assemblage métallique est de l'aluminium choisi dans le groupe constitué d'aluminium à plus de 89% d'aluminium en poids, d'aluminium à plus de 92% d'aluminium en poids, d'aluminium à plus de 99% d'aluminium en poids, d'aluminium à plus de 99,5% d'aluminium en poids et d'aluminium à plus de 99,99% d'aluminium en poids.

18. Mandrin électrostatique de l'une des revendications 14 à 16, dans lequel la deuxième couche de céramique (209, 300) a une surface de serrage, la deuxième couche de céramique recouvrant la couche d'assemblage métallique ayant une épaisseur choisie dans le groupe constitué par moins de 0,015 pouce (381 micromètres), 0,010 à 0,012 pouce (254 à 304,8 micromètres), 0,005 à 0,015 pouce (127 à 381 micromètres), 0,005 à 0,010 pouce (127 à 254 micromètres) et 0,006 pouce (152,4 micromètres).

19. Mandrin électrostatique de l'une des revendications 14 à 18, dans lequel le motif d'exclusion se poursuit à travers la première couche de céramique (201, 302) et la couche d'assemblage métallique et dans la deuxième couche de céramique (209, 300).
